# EUROPÄISCHE PATENTSCHRIFT

(11) **EP 2 936 128 B1**
(45) Veröffentlichungstag und Bekanntmachung des Hinweises auf die Patenterteilung: **26.10.2016**
(21) Anmeldenummer: 13814555.2
(22) Anmeldetag: 20.12.2013
(51) Int. Cl.: G01N 24/08, G01R 33/465

(54) **VERFAHREN ZUR BESTIMMUNG DER BLUTALKOHOLKONZENTRATION MITTELS QUANTITATIVER NMR-SPEKTROSKOPIE**
METHOD FOR DETERMINING BLOOD-ALCOHOL CONCENTRATION USING QUANTITATIVE NMR SPECTROSCOPY
PROCÉDÉ DE DÉTERMINATION DE LA CONCENTRATION D'ALCOOL DANS LE SANG PAR SPECTROSCOPIE RMN

(30) Priorität: 21.12.2012 DE 102012224334
(43) Veröffentlichungstag der Anmeldung: 28.10.2015
(73) Patentinhaber: Diehl, Bernd, 50678 Köln (DE)
(72) Erfinder: Diehl, Bernd, 50678 Köln (DE)
(74) Vertreter: Winter, Brandl, Fürniss, Hübner, Röss, Kaiser, Polte - Partnerschaft mbB
(86) Internationale Anmeldenummer: PCT/EP2013/077818
(87) Internationale Veröffentlichungsnummer: WO 2014/096411

(56) Entgegenhaltungen:
- CA-C- 1 288 475
- BOCK J L: "ANALYSIS OF SERUM BY HIGH FIELD PROTON NMR", CLINICAL CHEMISTRY, Bd. 28, Nr. 9, 1982, Seiten 1873-1877, XP002721009, & PROCEEDINGS OF THE 14TH ANNUAL SYMPOSIUM ON ADVANCED ANALYTICAL CONCEPTS FOR THE CLINICAL LABORATORY ISSN: 0009-9147
- MENDELSON J H ET AL: "In vivo proton magnetic resonance spectroscopy of alcohol in human brain", ALCOHOL, PERGAMON PRESS, LONDON, GB, Bd. 7, Nr. 5, 1. September 1990 (1990-09-01), Seiten 443-447, XP024399970, ISSN: 0741-8329, DOI: 10.1016/0741-8329(90)90030-G [gefunden am 1990-09-01]

## Beschreibung

Die vorliegende Erfindung betrifft ein Verfahren zur Bestimmung der Blutalkoholkonzentration, d.h der Bestimmung der Konzentration von Ethanol im Blut, in vitro und insbesondere ein Verfahren zur Bestimmung der Blutalkoholkonzentration mittels quantitativer ¹H-NMR-Spektroskopie in vitro.

Im deutschen Straßenverkehrsgesetz und Strafgesetzbuch ist festgelegt, ab welcher Blutalkoholkonzentration ein Verkehrsteilnehmer ordnungswidrig handelt bzw. eine Straftat begeht, wenn er in diesem Zustand ein Kraftfahrzeug führt.

Eine erste Abschätzung der Blutalkoholkonzentration (BAK) einer Person ist anhand einer relativ einfachen Messung der Konzentration des Alkohols in der Atemluft möglich. Eine derartige Abschätzung ist jedoch nur bedingt rechtlich verwertbar. Um einen eindeutig rechtlich verwertbaren Wert der Blutalkoholkonzentration zu erhalten, muss derzeit nach deutschem Recht die Blutalkoholkonzentration mittels einer Doppelbestimmung und unter Anwendung zweier unterschiedlicher Verfahren gemessen werden. Zudem dürfen die erhaltenen Konzentrationswerte nicht zu weit voneinander abweichen. Zur Durchführung der Doppelbestimmung muss der Person eine Menge von ca. 8 ml bis 10 ml an venösem Blut entnommen werden.

Zur Bestimmung der Blutalkoholkonzentrationen werden bislang zwei Standardverfahren angewendet, die Bestimmung mittels Gaschromatographie (GC), in der Regel mittels Headspace GC, und die Bestimmung mittels einer enzymatischen Methode, der ADH-Methode, bei der das Ethanol mit dem Enzym Alkoholdehydrogenase umgesetzt wird. Bei keinem der beiden Verfahren kann eine ausreichende Genauigkeit durch eine einmalige Eichung sichergestellt werden. Vielmehr müssen diese bei jeder Anwendung relativ aufwändig kalibriert werden.

Damit die geforderte Genauigkeit sichergestellt ist, erfordern beide Verfahren zudem einen gewissen instrumentellen, personellen und zeitlichen Aufwand. Schließlich darf die dazu notwendige Blutentnahme nur von einem approbierten Arzt durchgeführt werden. Die Untersuchung einer großen Zahl an Blutproben ist daher nur bedingt möglich.

Aus der zur Blutalkoholkonzentrationsbestimmung abgenommenen Blutprobe wird in der Regel das Blutserum gewonnen und für die durchzuführenden Messungen verwendet. Für den Fall dass zu einem späteren Zeitpunkt Vergleichsanalysen durchgeführt werden müssen, wird ein Teil des Blutserums tief gefroren, üblicherweise bei mindestens -20 °C. Dabei zeigte sich jedoch, dass nach der Blutentnahme relativ schnell ein Abbau des Ethanols stattfindet, so dass selbst bei einem Tiefgefrieren des Blutserums bereits nach einer Lagerzeit von einigen Monaten ein Großteil des Ethanols oder sogar der gesamte Ethanol verschwunden war. Um dennoch Aussagen über die Blutalkoholkonzentration zum Zeitpunkt der Blutentnahme machen zu können, wird daher versucht, den Gehalt der durch den Abbau des Ethanols entstandenen Metaboliten im Serum zu bestimmen und daraus die ursprüngliche Blutalkoholkonzentration rüchzurechnen. Die Abweichungen und Fehlerquellen sind hierbei naturgemäß relativ groß.

Wenn ein zu den oben genannten Analyseverfahren alternatives Verfahren eingesetzt werden soll, um rechtlich verwertbare Ergebnisse zu liefern, so ist gefordert, dass die erhaltenen Messwerte eindeutig auf ein zugelassenes Standardverfahren rückgeführt werden kann. Diese mit den Begriffen "Rückführbarkeit" oder "Traceability" bezeichnete Eigenschaft bedeutet, dass ein erhaltener Messwert durch eine ununterbrochene Kette von Vergleichsmessungen mit bekannter Messunsicherheit auf ein anerkanntes Standardverfahren bezogen werden kann.

Anwendungen der NMR-Spektroskopie zur Bestimmung von Metabolitenkonzentrationen in Zellsuspensionen und perfundierten Organen werden beschrieben von Gunby P., in "The new wave in medicine: Nuclear magnetic resonance. ", J. Am. Med. Assoc. 247, 151-159 (1982), bzw. Gadian D.G. und Radda G.K. in "NMR studies of tissue metabolism. "Annu. Rev. Biochem. 50, 69-83 (1981). Eine Analyse von Blutserum mittels ¹H-NMR-Spektroskopie zur Identifikation und quantitativen Bestimmung verschiedener Verbindung, darunter auch Alkohole, wird von Bock J.L. in "Analysis of Serum by High Field Proton Nuclear Magnetic Resonance" Clin. Chem. 28/9, 1873-1877 (1982) aufgezeigt.

Aufgabe der vorliegenden Erfindung ist die Bereitstellung eines Verfahrens zur Bestimmung der Blutalkoholkonzentration, mit dem eine große Probenzahl in kurzer Zeit und mit hoher Genauigkeit untersucht werden kann. Eine weitere Aufgabe ist die Bereitstellung eines Verfahrens zur Bestimmung der Blutalkoholkonzentration, das eine möglichst einfache Probenahme erlaubt, die auch von anderen Personen als Ärzten durchgeführt werden kann. Zudem soll das Verfahren eine Rückführbarkeit der Messergebnisse erlauben und soll damit auch die Analyse von über längere Zeit gelagerter Proben möglich sein.

Die Aufgabe wird gelöst durch ein Verfahren zur Bestimmung der Blutalkoholkonzentration mittels ¹H-NMR-Spektroskopie in einer Blutprobe in vitro, wobei die Blutprobe Vollblut ist, umfassend die Schritte:
a) Aufnehmen und Abmessen einer vorgegebenen Menge an Vollblut mittels einer Kapillare;
b) Mischen der vorgegebenen Menge an Vollblut aus Schritt a) mit einem volumenbezogenen Überschuss eines deuterierten Lösungsmittels und mit einer vorgegebenen Menge eines internen Standards,
c) Erstellen eines ¹H-NMR-Spektrums von der in Schritt b) erhaltenen Mischung und
d) Ermitteln der Konzentration an Ethanol in der Blutprobe durch Vergleich der Signale des Ethanols mit den Signalen des internen Standards im erstellten ¹H-NMR-Spektrum.

In der vorliegenden Anmeldung bedeutet der Begriff "Vollblut" ein Blutprodukt, das alle nativen, d.h. physiologisch vorkommenden, Blutbestandteile wie Zellen, Proteine und sonstige Bestandteile enthält. Vollblut ist daher verschieden zu Blutserum oder Blutplasma.

Die Erfinder der vorliegenden Erfindung haben herausgefunden, dass mittels quantitativer ¹H-Kernresonanzspektroskopie (¹H-NMR-Spektroskopie) eine schnelle und genaue Bestimmung der Blutalkoholkonzentration möglich ist, so dass eine große Probenzahl in kurzer Zeit und mit hoher Genauigkeit untersucht werden kann.

Die ¹H-NMR-Spektroskopie ist ein analytisches Verfahren, das sehr gut standardisiert werden kann und hervorragend für die automatisierte Bearbeitung großer Probenmengen geeignet ist.

Darüber hinaus ist die ¹H-NMR-Spektroskopie ein Verfahren, das zerstörungsfrei arbeitet. Eine Probe kann somit mehrfach und damit auch an verschiedenen Orten und Geräten untersucht werden ohne dass die Probe durch die Messungen verändert wird. Damit ist eine einfache nachträgliche Verifizierung der erhaltenen Ergebnisse möglich. Aus diesem Grund ist auch nach einer Blutalkoholbestimmung mittels ¹H-NMR-Spektroskopie eine eindeutige Zuordnung der Probe zu dem Probanden, d.h. der Person von der die Blutprobe stammt, möglich, indem ein DNA-Profil von der Blutprobe und dem Probanden erstellt wird, vorzugsweise unter Anwenden einer Polymerase-Kettenreaktion (PCR).

Ein weiterer Vorteil der ¹H-NMR-Spektroskopie ist deren Eichfähigkeit. Eine Eichung kann auf einfache Weise, beispielsweise durch entsprechende offizielle Eichproben, durchgeführt werden. Damit ist die geforderte Traceability (Rückführbarkeit) der erhaltenen Messwerte sicher gestellt, ist eine erhöhte Akzeptanz für das Verfahren gegeben und ist der Ersatz der derzeit vorgeschriebenen Standardverfahren durch die quantitative ¹H-NMR-Spektroskopie möglich.

Die Erfinder der vorliegenden Erfindung haben ferner überraschenderweise herausgefunden, dass durch die Zugabe eines volumenbezogenen Überschusses an deuteriertem Lösungsmittel zu dem entnommenen Blut (Vollblut) die erhaltene Blutprobe gegenüber einer Veränderung der Konzentration an Ethanol, durch Abbau oder andere Effekte, stabilisiert werden kann. Selbst bei einer mehrmonatigen Lagerung der auf diese Weise stabilisierten Blutprobe bei Raumtemperatur war die Blutalkoholkonzentration kaum oder nur geringfügig verändert. Dies ist insbesondere überraschen, da die Proben bei Raumtemperatur gelagert wurden. Wenn die Proben nach der Zugabe des deuterierten Lösungsmittels gekühlt werden, vorzugsweise unter 0 °C, weiter bevorzugt bei mindestens -20 °C, so ist eine noch bessere Stabilisierung möglich.

Die Erfinder der vorliegenden Erfindung haben zudem herausgefunden, dass wenn bei der Bestimmung der Blutalkoholkonzentration als Vollblut Kapillarblut verwendet wird, dies zu denselben Ergebnissen führt wie bei der Verwendung von venösem Blut, dessen Verwendung bisher gefordert ist. In Kombination mit der Analyse mittels ¹H-NMR-Spektroskopie konnte darauf basierend als eine bevorzugte Ausführungsform des oben beschriebenen erfindungsgemäßen Verfahrens ein weiter verbessertes Verfahren zur Bestimmung der Blutalkoholkonzentration in vitro bereitgestellt werden. Dieses gestattet nicht nur eine schnelle Verarbeitung großer Mengen an Proben, sondern ermöglicht auch eine relativ einfache Probenahme, durch die Entnahme von Kapillarblut, ohne dass die hohe Genauigkeit des Verfahrens beeinträchtigt wird. Ein besonderer Vorteil dieser speziellen Ausführungsform ist, dass die Entnahme der Blutprobe auch von anderen Personen als Ärzten durchgeführt werden kann bzw. darf.

Mit Kapillarblut wird Blut bezeichnet, das in den Kapillargefäßen des Körpers, d.h. den Endabschnitten des Gefäßsystems enthalten ist. Es wird üblicherweise durch Punktion eines gut durchbluteten Körperteils wie der Fingerkuppe (Fingerbeere), des Ohrläppchens oder der Ferse entnommen. Zur Punktion kann beispielsweise eine Lanzette verwendet werden.

Mit dem erfindungsgemäßen Verfahren ist nur eine geringe Blutmenge erforderlich, um die Messung durchzuführen. So ist es ausreichend, wenn bis zu 100 µl, vorzugsweise bis zu 50 µl, weiter bevorzugt 3 bis 30 µl und am meisten bevorzugt 5 bis 20 µl an Blut, vorzugsweise Kapillarblut, entnommen werden. Im Gegensatz dazu sind bei den bisher angewendeten Verfahren deutlich größere Blutvolumina notwendig, üblicherweise 8 ml bis 10 ml.

In dem erfindungsgemäßen Verfahren wird das Vollblut mittels einer Kapillare (Kapillarpipette) aufgenommen. Derartige Kapillaren werden bereits für eine Vielzahl an Blutuntersuchungen eingesetzt und können aus Glas oder Kunststoff hergestellt sein. Sie sind in verschiedenen Größen von 1 µl bis 100 µl erhältlich und ermöglichen eine einfache und genaue Abmessung einer vorbestimmten Menge an Blut. Ein Vorteil der Entnahme der Blutprobe mittels einer Kapillare ist, dass bereits bei der Probenahme eine genau definierte Menge abgemessen wird, so dass ein späteres Abwiegen oder Abmessen im Labor entfällt.

Die üblicherweise für Blutentnahmen verwendeten Kapillaren sind mit Beschichtungen wie Heparin, Citrat oder EDTA erhältlich, die eine Blutgerinnung verhindern. Bei dem erfindungsgemäßen Verfahren ist eine derartige Beschichtung nicht notwendig. Jedoch selbst wenn beschichtete Kapillaren verwendet werden, wird die Analyse mittels ¹H-NMR-Spektroskopie nicht beeinträchtigt, da die dadurch zusätzlich im Spektrum erscheinenden Peaks die Auswertung nicht stören.

Zudem kann bei dem erfindungsgemäßen Verfahren eine Gerinnung des entnommenen Bluts auch dadurch verhindert werden, dass die entnommene Blutprobe unmittelbar nach der Entnahme mit dem Lösungsmittel in Kontakt gebracht wird. Wie bereits oben dargelegt, wird die Blutprobe dadurch auch gegenüber einem Abbau des Ethanols stabilisiert.

Wird in dem erfindungsgemäßen Verfahren Kapillarblut als Vollblut verwendet, wird dieses vorzugsweise am Ohrläppchen oder einer Fingerkuppe (Fingerbeere) entnommen, da diese Körperteile einfach zugängig sind. Ein besonderer Vorteil bei der Verwendung von Kapillarblut in dem erfindungsgemäßen Verfahren ist die einfache Blutentnahme. Zum einen ist sie relativ schnell und sicher durchführbar, so dass eine große Anzahl an Proben in kurzer Zeit genommen werden kann. Zum anderen kann sie auch von entsprechend angeleiteten Personen durchgeführt werden kann, so dass die Notwendigkeit der Anwesenheit eines Arztes zur Blutentnahme entfällt.

Als das in Schritt b) des erfindungsgemäßen Verfahrens zugegebene Lösungsmittel kann prinzipiell jedes Lösungsmittel für die ¹H-NMR-Spektroskopie verwendet werden, das eine ¹H-NMR-spektroskopische Untersuchung von Blut ermöglicht. Als bevorzugte Lösungsmittel können D₂O oder perdeuteriertes Methanol (Methanol-d₄) verwendet werden, da sie gut mit dem Blut vermischbar sind. Besonders bevorzugt ist die Verwendung von D₂O als das Lösungsmittel, das im Schritt b) des erfindungsgemäßen Verfahrens zugegeben wird. Da Wasser ein Hauptbestandteil des Blutes ist, wird D₂O die Probenmatrix kaum beeinflussen und können auch für die Messung störende Wechselwirkungen ausgeschlossen werden. Außerdem ist bei der Verwendung von D₂O als Lösungsmittel eine wie oben erwähnte nachträgliche Analyse des genetischen Materials mittels PCR ohne Probleme möglich. Die Menge an zugegebenem deuteriertem Lösungsmittel ist nicht speziell beschränkt, insofern es in einem volumenbezogenen Überschuss zu dem entnommenen Blut zugegeben wird und damit ein ausreichendes Volumen einer homogenen Mischung erhalten wird, von der dann im Schritt c) des erfindungsgemäßen Verfahrens ein ¹H-NMR-Spektrum erstellt werden kann. Die bevorzugte Menge an im Schritt b) des erfindungsgemäßen Verfahrens zugegebenem deuteriertem Lösungsmittel beträgt daher 0,1 - 4,0 ml, weiter bevorzugt 0,3 - 3,0 ml und am meisten bevorzugt 0,5 - 2,0 ml. Die Zugabe einer zu großen Menge an deuteriertem Lösungsmittel würde die Probe nur unnötigerweise stark verdünnen und die Empfindlichkeit verschlechtern.

Bei dem erfindungsgemäßen Verfahren wird im Schritt b) eine vorgegebene Menge eines internen Standards zugegeben. Dieser dient als eine Referenzsubstanz mit deren Hilfe der Gehalt an Ethanol in der Blutprobe berechnet werden kann. Der interne Standard wird im Schritt b) vorzugsweise in gelöster Form als Standardlösung in einem deuteriertem Lösungsmittel zugegeben, wobei die Standardlösung eine vorgegebene Konzentration des internen Standards aufweist. Als Lösungsmittel für die Standardlösung kann dasselbe Lösungsmittel verwendet werden, das im Schritt b) zugegeben wird oder es kann ein anderes geeignetes Lösungsmittel verwendet werden, das die Standardsubstanz löst und die ¹H-NMR-spektroskopische Messung nicht beeinträchtigt.

Die Abmessung eines definierten Volumens an Standardlösung kann gemäß einer bevorzugten Ausführungsform mittels einer wie oben beschriebenen Kapillare (Kapillarpipette) geschehen.

Für die Methode kann prinzipiell eine Vielzahl an bei der ¹H-NMR-Spektroskopie üblichen internen Standards verwendet werden. Der verwendete interne Standard sollte vorzugsweise in der Probenmatrix löslich sein und sollte sein Signal im ¹H-NMR-Spektrum an einer Stelle auftreten, bei der keine Überlappung mit den Signalen der zu bestimmenden Substanz stattfindet. Bevorzugt sind zudem interne Standards, deren Relaxationszeiten in der Nähe der des Ethanols liegen, so dass Messungenauigkeiten ausgeschlossen sind. Die geeignete Auswahl eines geeigneten internen Standards stellt für den Fachmann kein Problem dar. Wird in einer bevorzugten Ausführungsform des erfindungsgemäßen Verfahrens D₂O als Lösungsmittel verwendet, so kann beispielsweise Dimethylsulfon (DMS) als interner Standard verwendet werden. DMS ist in ausreichendem Maße wasserlöslich und dessen Signal erscheint bei einer chemischen Verschiebung δ von ca. 3,156.

Werden interne Standards verwendet, deren Relaxationszeiten deutlich verschieden sind von denen des Ethanols, wie beispielsweise Ethylsulfon, muss ein Responsefaktor bei der Auswertung mit eingerechnet werden. Werden derartige Responsefaktoren berücksichtigt, kann somit jeder für die quantitative ¹H-NMR geeignete interne Standard verwendet werden.

Da in dem erfindungsgemäßen Verfahren in der im Schritt b) erhaltenen Mischung sowohl eine genau definierte Menge an Blut wie auch eine genau definierte Menge des internen Standards enthalten sind und da die Integrale der in dem in Schritt c) erhaltenen ¹H-NMR-Spektrum erscheinenden Signale (Peaks) des Standards und des Ethanols proportional zu der Anzahl an Wasserstoffatomen sind, kann im Schritt d) des erfindungsgemäßen Verfahrens durch Vergleich der Signale des Ethanols mit den Signalen des internen Standards im erstellten ¹H-NMR-Spektrum die Konzentration von Ethanol im Blut berechnet werden. Der oben genannte Vergleich der Signale bedeutet einen Vergleich der Integrale der Signale, d.h. der Flächen unter den Signalen (Peakflächen).

Im Speziellen, werden dabei in dem gemessenen NMR-Spektrum getrennt die Signale des Ethanols (oder nur einer Gruppe des Ethanols, wie der CH₃-Gruppe oder der CH₂-Gruppe) und der Referenzsubstanz (der interne Standard) integriert. Dabei wird davon ausgegangen, dass jedes Wasserstoffatom, dessen Signale im Spektrum erscheinen, einen gleichgroßen Anteil zu den Integralen aller Signale beiträgt, so dass die Zahl der Atome proportional zu den Integralen, d.h. den Peakflächen, ist. Aus dem Verhältnis der Integrale und unter Berücksichtigung der Massen und Molmassen von Ethanol und Referenzsubstanz und der Anzahl der Kerne deren Signale integriert wurden, kann die Stoffmenge des in der Blutprobe enthaltenen Ethanols berechnet werden.

Die Zuordnung der Signale im ¹H-NMR-Spektrum zu den in der Probe enthaltenen Verbindungen kann mittels Messungen von Reinsubstanzen sowie mithilfe Literaturdaten erfolgen. Ethanol wird über ein Triplett mit einer chemischen Verschiebung von 1,19 ppm und über ein Quartett bei δ = 3,66 ppm identifiziert. Die Quantifizierung kann über jedes der Signale erfolgen, wobei bevorzugt das Triplett aufgrund seiner größeren Intensität zur Quantifizierung der in der Probe enthaltenen Menge an Ethanol verwendet wird. Bei der Messung der Peakflächen ist, falls notwendig, eine Basislinienkorrektur durchzuführen. Die Messung der Peakflächen kann manuell oder automatisiert durchgeführt werden.

Bei der im Schritt b) des erfindungsgemäßen Verfahrens definierten Zugabe eines deuterierten Lösungsmittels und einer vorgegebenen Menge eines internen Standards zu dem entnommenen Blut ist keine bestimmte Reihenfolge der Zugabe bzw. des Vermischens der einzelnen Komponenten Lösungsmittel, Standard und Blut vorgegeben. Das heißt, die Komponenten können in beliebiger Reihenfolge zusammengebracht und vermischt werden. Als bevorzugte Ausführungsform des erfindungsgemäßen Verfahrens wird das entnommene Blut allerdings zuerst mit dem deuterierten Lösungsmittel vermischt, da dann eine Gerinnung des Blutes verhindert werden kann und eine stabilisierte Probe erhalten wird. Diese bevorzugte Ausführungsform umfasst dabei auch die Variante, dass das deuterierte Lösungsmittel in einem geeigneten Probengefäß vorgelegt wird und die entnommene Blutprobe zu dem vorgelegten Lösungsmittel gegeben wird und die Variante, dass das deuterierte Lösungsmittel und der interne Standard in einem geeigneten Probengefäß vorgelegt werden und die entnommene Blutprobe zu dem vorgelegten Lösungsmittel und internen Standard gegeben wird. Bei dieser bevorzugten Ausführungsform und den zugehörigen Varianten ist D₂O das bevorzugte Lösungsmittel.

Als Probengefäß wird vorzugsweise ein luftdicht verschließbares Probengefäß aus Glas oder Kunststoff verwendet, das eine ausreichende Größe aufweist, um alle zur Vorbereitung der Proben notwendigen Komponenten aufnehmen zu können. Probengefäße aus Glas sind bevorzugt, da Glas eine geringe Wechselwirkung mit der Probe sicherstellt.

In dem erfindungsgemäßen Verfahren kann vordem Erstellen eines ¹H-NMR-Spektrum im Schritt c) von der im Schritt b) erhaltenen Mischung noch eine Referenzsubstanz zugegeben werden, die eine Zuordnung der chemischen Verschiebungen der einzelnen Signale im Spektrum ermöglicht. Derartige Referenzsubstanzen sind auf dem Gebiet gut bekannt und es können beispielhaft TMS (Tetramethylsilan) und TMSP (Trimethylsilylpropionsäure-d₄ oder dessen Natriumsalz) genannt werden. Deren Signalen wird im ¹H-NMR-Spektrum die chemische Verschiebung von 0,00 zugeordnet. In wässrigen Medien, wie bei der Verwendung von D₂O als Lösungsmittel, ist TMSP als Referenzsubstanz zur Zuordnung der chemischen Verschiebungen bevorzugt.

Weitere Vorteile und Merkmale der vorliegenden Erfindung ergeben sich aufgrund der Beschreibung von Ausführungsbeispielen sowie anhand der Zeichnungen.

Gemäß einer bevorzugten Ausführungsform der vorliegenden Erfindung umfasst das erfindungsgemäße Verfahren auch einen Schritt des Entnehmens einer vorgegebenen Menge an Blut (Vollblut), vorzugsweise Kapillarblut, bei einer Person.

Es zeigt:
- Fig. 1: ein beispielhaftes ¹H-NMR-Spektrum einer Ethanol enthaltenden Probe;
- Fig. 2: eine grafische Darstellung der Verteilung der Abweichungen der Blutalkoholkonzentrationen von Proben, die mit dem erfindungsgemäßen Verfahren gemessen wurden gegenüber Mittelwerten der Blutalkoholkonzentrationen derselben Proben, die von der Rechtsmedizin mittels Standardverfahren gemessen wurden;
- Fig. 3: das ¹H-NMR-Spektrum der venösen Blutprobe A des Teilnehmers X03 am Trinktest;
- Fig. 4: das ¹H-NMR-Spektrum der venösen Blutprobe B des Teilnehmers X03 am Trinktest;
- Fig. 5: das ¹H-NMR-Spektrum von Kapillarblut aus dem rechten Ohrläppchen des Teilnehmers X03 am Trinktest;
- Fig. 6: das ¹H-NMR-Spektrum von Kapillarblut aus dem rechten Zeigefinger des Teilnehmers X03 am Trinktest;
- Fig. 7: das ¹H-NMR-Spektrum der venösen Blutprobe A des Teilnehmers X12 am Trinktest;
- Fig. 8: das ¹H-NMR-Spektrum der venösen Blutprobe B des Teilnehmers X12 am Trinktest;
- Fig. 9: das ¹H-NMR-Spektrum von Kapillarblut aus dem rechten Zeigefinger des Teilnehmers X12 am Trinktest;
- Fig. 10: das ¹H-NMR-Spektrum von Kapillarblut aus dem rechten Ohrläppchen des Teilnehmers X12 am Trinktest; und
- Fig. 11: einen Vergleich der Messungen der Blutalkoholkonzentration in Blutproben, die durch Zugabe von deuteriertem Lösungsmittel stabilisiert wurden, nach der Blutentnahme und nach einer Lagerung der gemessenen Proben während 7 Monaten bei Raumtemperatur.

Im Folgenden wird das erfindungsgemäße Verfahren beispielhaft von der Probenahme bis zur Messung beschrieben.

In ein luftdicht verschließbares Probengefäß aus Glas oder Kunststoff mit ausreichendem Volumen wird mithilfe einer Spritze ein definiertes Volumen eines mit einer Blutprobe mischbaren deuterierten Lösungsmittels, wie beispielsweise D₂O, gegeben. Zur Nullkalibrierung der chemischen Verschiebungswerte im ¹H-NMR-Spektrum wird zudem eine geeignete Referenzsubstanz zu dem deuterierten Lösungsmittel gegeben, wie beispielsweise TMSP oder TMS.

Um eine definierte Menge einer Lösung eines internen Standards abzumessen, wird eine Kapillare mit bekannten Volumen mit einer Standardlösung mit bekannter Konzentration des internen Standards gefüllt, indem die Kapillare schräg in die Lösung des internen Standards gehalten wird, so dass durch die Kapillarkräfte die Flüssigkeit in der Kapillare hoch steigt. Hierbei ist darauf zu achten, dass die Kapillare vollständig gefüllt ist und sich keine Luftbläschen in ihr befinden. Äußere Anhaftungen an der Kapillare werden nach deren Befüllen entfernt. Die mit der Lösung des internen Standards gefüllte Kapillare wird in das oben genannte Probengefäß mit dem vorgelegten Lösungsmittel eingeführt. Die Kapillare kann im Probengefäß verbleiben oder man lässt den Inhalt der Kapillare ins Probengefäß ablaufen und entsorgt die leere Kapillare.

Mittels einer Kapillare mit bekanntem Volumen wird eine definierte Menge an Blut eines Probanden abgemessen. Gemäß einer bevorzugten Ausführungsform geschieht dies durch Punktieren eines Kapillargefäßes in einer Fingerkuppe oder eines Ohrläppchens mittels einer Lanzette und Aufnahme des austretenden Blutstropfens mittels der Kapillare. Die von äußeren Anhaftungen befreite und mit Kapillarblut gefüllte Kapillare wird ebenfalls dem oben genannten Probengefäß zugeführt. Auch hier kann die Kapillare im Probengefäß verbleiben oder man lässt den Inhalt der Kapillare ins Probengefäß ablaufen und entsorgt die leere Kapillare.

Der Inhalt des Probengefäßes wird gut durchmischt, beispielsweise mittels eines Schüttlers. Sind die zur Abmessung der Blutprobe und des Standards verwendeten Kapillaren noch im Probengefäß enthalten, so wird durch das Schütteln das Lösungsmittel mit den Inhalten der Kapillaren homogen vermischt. Es wird dann ein definiertes Volumen der erhaltenen Probe in ein NMR-Röhrchen überführt und mit einem ¹H-NMR-Spektrometer gemessen. Die geeigneten Einstellungen sind dem Fachmann gut bekannt. Beispielhaft können bei einer Spektrometerfrequenz (SF) von 300 MHz oder mehr eine Scan-Anzahl (NS) von 8-512 und ein Relaxationsdelay (D₁) von 1-20 s genannt werden.

Nach der Kalibrierung der chemischen Verschiebungen durch Setzen des TMSP-Signals auf 0,00 ppm wird die Integration der Ethanol-Signale und des internen Standards durchgeführt. Vorzugsweise wird bei der Integration der Ethanol-Signale nur das Triplett-Signal der CH₂-Gruppe bei δ = 1,19 ppm verwendet. Wenn dieses mit anderen Signalen überlappt, kann auch das Quartett-Signal der CH₃-Gruppe bei δ = 3,66 ppm verwendet werden. Aus der bekannten Stoffmenge an in der vermessenen Probe enthaltenem internem Standard und dem Verhältnis der Integrale von Standard und Ethanol kann die Stoffmenge an Ethanol in der Probe und somit auch die Blutalkoholkonzentration berechnet werden.

### Beispiel 1

Im Folgenden wird das erfindungsgemäße Verfahren als beispielhafte Ausführungsform ausführlicher beschrieben.

In ein luftdicht verschließbares Probengefäß aus Glas oder Kunststoff mit einem Volumen von ca. 1,2 ml wurde mithilfe einer Spritze ein Volumen von 1 ml an D₂O + TMSP gegeben. D₂O dient als deuteriertes Lösungsmittel (Lieferant: Eurisotop^{®}, Saint-Aubin Cedex, Frankreich), TMSP (Lieferant: Merck, Darmstadt, Deutschland) als Nullkalibrierung der chemischen Verschiebungswerte im ¹H-NMR-Spektrum.

Mittels einer 20 µl Einmal-Kapillarpipette aus Glas (Lieferant: Hirschmann Laborgeräte GmbH & Co. KG, Eberstadt, Deutschland) wurde eine Lösung von Dimethylsulfon in D₂O, Konzentration 0,5027 g/l, als interner Standard abgemessen und die Kapillare in das Probengefäß gegeben. Ebenfalls mit einer 20 µl Einmal-Kapillarpipette aus Glas wurde Kapillarblut, das kurz zuvor einem Probanden an der Fingerkuppe des Zeigefingers entnommen wurde abgemessen und in das Probengefäß gegeben.

Das Probengefäß wurde verschlossen und der Inhalt mittels eines Schüttlers (Typ: KS 501 D; Hersteller: IKA^{®}-Werke GmbH & CO. KG, Staufen, Deutschland) während 5 Minuten bei 180 Upm und anschließend mittels eines Vortexers (Typ: MS 2 Minishaker; Hersteller: IKA^{®}-Werke GmbH & CO. KG, Staufen, Deutschland) während ca. 5 s bei 2500 Upm gut durchmischt.

Mittels einer Eppendorf-Pipette wurden 0,5 ml der erhaltenen Mischung in ein 0,5 mm NMR-Röhrchen überführt und dieses in einem 600 MHz ¹H-NMR-Spektrometer vermessen (Hersteller: BRUKER, Billerica, MA, USA), das einen.

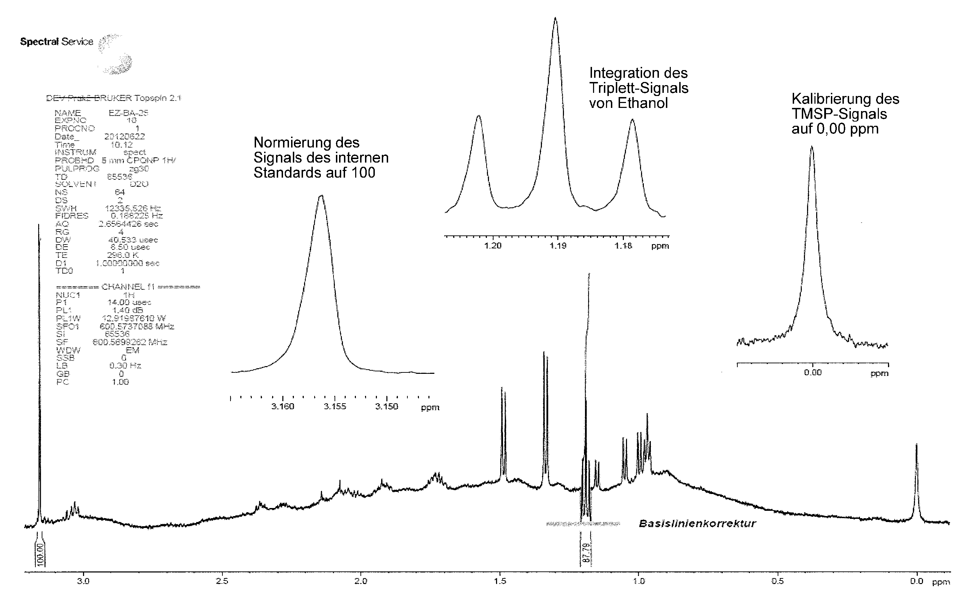

Als Ergebnis wurde das in Fig. 1 gezeigte ¹H-NMR-Spektrum erhalten, das bei einer Spektrometerfrequenz (SF) von 600 MHz einer Scan-Anzahl (NS) von 64 und einen Relaxationsdelay (D₁) von 1 s aufgenommen wurde. In Fig. 1 sind zusätzlich zu dem Spektrum über einen Bereich der chemischen Verschiebung von 0 bis ca. 3,2 ppm vergrößert die Peaks des internen Standards (IT) bei ca. 3,156 ppm (Singulett), der CH₂-Gruppe des Ethanols bei ca. 1,19 ppm (Triplett) und das definitionsgemäß bei 0,00 ppm erscheinende Signal vom TMSP (Singulett) abgebildet.

Nach der Kalibrierung der chemischen Verschiebungen durch Setzen des TMSP-Signals auf 0,00 ppm wurde die Integration des Ethanol-Tripletts bei δ = 1,19 ppm und des Singuletts des internen Standards bei δ = 3,156 ppm durchgeführt. Der Integrationsbereich betrug dabei ± eine Halbwertsbreite. Vor der Integration des Ethanol-Tripletts war bei diesem Signal eine Basislinienkorrektur notwendig. In dem in Fig. 1 dargestellten Spektrum sind die Peakflächen normiert auf den Wert von 100,00 für das Signal des internen Standards angegeben.

### Beispiel 2

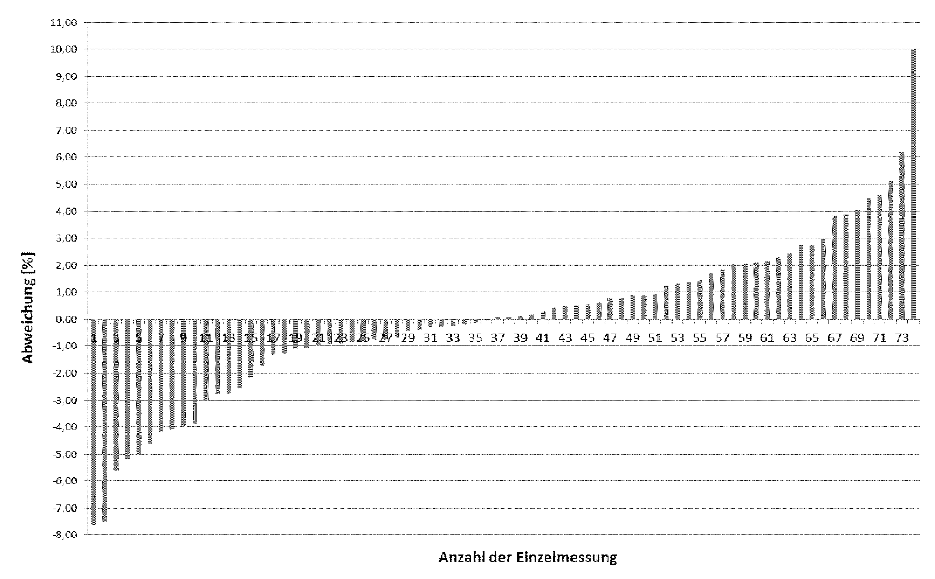

Um die Vergleichbarkeit der mittels des erfindungsgemäßen Verfahrens erhaltenen Werte der Blutalkoholkonzentration mit den mittels der bisherigen Standardverfahren erhaltenen Werten zu ermitteln, wurden 74 reale Blutproben aus der Rechtsmedizin mit einem Blutalkoholkonzentration von 0 bis über 3 Promille erneut mit dem erfindungsgemäßen Verfahren gemessen und die Ergebnisse miteinander verglichen. Die Verteilung der Abweichungen der von der Rechtsmedizin ermittelten Mittelwerte der Blutalkoholkonzentration (gemessen mittels ADH und Headspace GC) von den mittels ¹H-NMR-Spektroskopie gemäß dem erfindungsgemäßen Verfahren gemessenen Werten sind der Fig. 2 zu entnehmen. Die in Fig. 2 gezeigte Verteilung der Abweichungen ist symmetrisch und zeigt damit, dass das erfindungsgemäße Verfahren keinen systematischen Fehler aufweist. Zudem zeigten lediglich 6 der Proben Abweichungen vom mehr als ± 5 % auf. Die Gründe hierfür können die einsetzende Alterung der Proben oder falsche Lagerung sein.

Durch diesen einfachen Vergleich wird deutlich, dass das erfindungsgemäße Verfahren Blutalkoholkonzentrationswerte liefert, die ausreichend genau und auch gut vergleichbar sind mit den bisherigen Standardverfahren zur Messung der Blutalkoholkonzentration.

### Beispiel 3

Es wurde ein wissenschaftlicher Trinktest durchgeführt, um die Vergleichbarkeit der mittels ¹H-NMR-Spektroskopie gemessenen Blutalkoholkonzentrationen im venösen und kapillaren Blut zu ermitteln.

An dem Trinktest nahmen 21 Probanden teil, davon acht weibliche und 13 männliche. Das Alter der Probanden variiert zwischen 21 und 52 Jahren. Eine Übersicht über die Probanden in Bezug auf Geschlecht, Größe und Gewicht und Alter ist der Tabelle 1 zu entnehmen.

**Tabelle 1: Geschlecht, Größe und Gewicht und Alter der Probanden**

| Proband | Geschlecht | Größe [kg] | Gewicht [cm] | Alter [Jahre] |
|---|---|---|---|---|
| X01 | m | 178 | 71 | 25 |
| X02 | m | 184 | 88 | 24 |
| X03 | m | 181 | 100 | 52 |
| X04 | m | 178 | 84 | 29 |
| X06 | m | 180 | 77 | 21 |
| X07 | w | 155 | 53 | 30 |
| X08 | w | 170 | 57 | 22 |
| X09 | w | 172 | 65 | 23 |
| X11 | m | 185 | 73 | 22 |
| X12 | w | 173 | 62 | 22 |
| X13 | m | 190 | 75 | 22 |
| X14 | m | 184 | 68 | 22 |
| X15 | m | 180 | 79 | 22 |
| X16 | w | 173 | 59 | 22 |
| X17 | m | 186 | 64 | 26 |
| X18 | w | 164 | 58 | 23 |
| X19 | w | 160 | 52 | 23 |
| X20 | m | 175 | 75 | 46 |
| X21 | m | 190 | 72 | 24 |
| X22 | w | 168 | 59 | 24 |
| X24 | m | 176 | 67 | 26 |

Trinkbeginn, Trinkende, Art, Menge und Alkohol-Volumenprozent der Getränke wurden von jedem Probanden notiert. Die Getränke wurden in möglichst gleichmäßiger Geschwindigkeit konsumiert, wobei die Trinkphase ca. 3 Stunden betrug. Um eine ausreichende Resorptionsphase sicherzustellen, beendeten die Probanden die Alkoholaufnahme mindestens eine halbe Stunde vor der Blutentnahme.

Bis auf den Probanden X16 und X24 wurde jedem Probanden sowohl venöses Blut aus der rechten oder der linken Armbeuge wie auch Kapillarblut aus einem Ohrläppchen und/oder aus einer Zeigefingerkuppe entnommen. Die Blutentnahmen wurden von einer ausgebildeten Krankenschwester sowie einem Rettungsassistenten durchgeführt.

Alle Blutproben wurden entsprechend der in Beispiel 1 aufgezeigt Vorgehensweise mittels ¹H-NMR-Spektroskopie auf ihre Blutalkoholkonzentration untersucht. Die Ergebnisse sind in Tabelle 2 zusammengefasst. Zur Auswertung wurden als Signale des Ethanols nur die Integrale der Signale der CH₃-Gruppe des Ethanols, d.h. des Ethanol-Quartetts, herangezogen, da bei einigen Spektren Überlagerungen mit Signalen von Isopropanol, das zur Desinfektion verwendet wurde, auftraten.

**Tabelle 2: Messergebnisse des Trinktests**

| Proband | Ort der Blutentnahme | Integral des Quartetts | Konzentration [g/l] | Konzentration [g/kg] |
|---|---|---|---|---|
| X01 | iv | 216,49 | 1,59 | 1,50 |
| | iv | 228,76 | 1,68 | 1,59 |
| | FR | 224,70 | 1,65 | 1,56 |
| | FL | 220,48 | 1,62 | 1,53 |
| X02 | iv | 99,82 | 0,73 | 0,69 |
| | iv | 105,47 | 0,78 | 0,73 |
| | FR | 82,92 | 0,61 | 0,58 |
| | FL | 83,03 | 0,61 | 0,58 |
| X03 | iv | 161,46 | 1,19 | 1,12 |
| | iv | 165,23 | 1,22 | 1,15 |
| | FR | 160,79 | 1,18 | 1,12 |
| | OR | 164,19 | 1,21 | 1,14 |
| X04 | iv | 128,17 | 0,94 | 0,89 |
| | iv | 130,53 | 0,96 | 0,91 |
| | FR | 132,63 | 0,98 | 0,92 |
| | OR | 132,76 | 0,98 | 0,92 |
| X06 | iv | 133,92 | 0,99 | 0,93 |
| | iv | 136,06 | 1,00 | 0,94 |
| | FL | 136,21 | 1,00 | 0,95 |
| | FL | 127,19 | 0,94 | 0,88 |
| X07 | iv | 113,32 | 0,83 | 0,79 |
| | iv | 110,80 | 0,82 | 0,77 |
| | OR | 108,80 | 0,80 | 0,75 |
| | OR | 102,81 | 0,76 | 0,71 |
| X08 | iv | 75,05 | 0,55 | 0,52 |
| | iv | 78,62 | 0,58 | 0,55 |
| | FR | 75,00 | 0,55 | 0,52 |
| | FL | 72,27 | 0,53 | 0,50 |
| X09 | iv | 60,57 | 0,45 | 0,42 |
| | iv | 60,80 | 0,45 | 0,42 |
| | OL | 59,18 | 0,44 | 0,41 |
| | OR | 56,88 | 0,42 | 0,39 |
| X11 | iv | 174,63 | 1,28 | 1,21 |
| | iv | 172,07 | 1,27 | 1,19 |
| | FR | 173,40 | 1,28 | 1,20 |
| | FR | 164,07 | 1,21 | 1,14 |
| X12 | iv | 0,00 | 0,00 | 0,00 |
| | iv | 0,00 | 0,00 | 0,00 |
| | FR | 0,00 | 0,00 | 0,00 |
| | OR | 0,00 | 0,00 | 0,00 |
| X13 | iv | 175,74 | 1,29 | 1,22 |
| | iv | 175,07 | 1,29 | 1,21 |
| | FR | 165,16 | 1,21 | 1,15 |
| | OL | 180,84 | 1,33 | 1,25 |
| X14 | iv | 289,92 | 2,13 | 2,01 |
| | iv | 284,13 | 2,09 | 1,97 |
| | FR | 291,63 | 2,15 | 2,02 |
| | FR | 290,69 | 2,14 | 2,02 |
| X15 | iv | 251,17 | 1,85 | 1,74 |
| | iv | 248,47 | 1,83 | 1,72 |
| | FR | 248,01 | 1,82 | 1,72 |
| | FR | 255,31 | 1,88 | 1,77 |
| X16 | OL | 102,04 | 0,75 | 0,71 |
| | OR | 100,42 | 0,74 | 0,70 |
| X17 | iv | 126,04 | 0,93 | 0,87 |
| | iv | 120,40 | 0,89 | 0,84 |
| | OR | 105,81 | 0,78 | 0,73 |
| | OL | 105,95 | 0,78 | 0,74 |
| X18 | iv | 152,65 | 1,12 | 1,06 |
| | iv | 159,54 | 1,17 | 1,11 |
| | FR | 151,40 | 1,11 | 1,05 |
| | OL | 146,61 | 1,08 | 1,02 |
| X19 | iv | 51,21 | 0,38 | 0,36 |
| | iv | 49,52 | 0,36 | 0,34 |
| | FR | 49,43 | 0,36 | 0,34 |
| | FR | 50,12 | 0,37 | 0,35 |
| X20 | iv | 61,42 | 0,45 | 0,43 |
| | iv | 68,66 | 0,51 | 0,48 |
| | OL | 64,37 | 0,47 | 0,45 |
| | OL | 64,16 | 0,47 | 0,45 |
| X21 | iv | 255,81 | 1,88 | 1,78 |
| | iv | 252,42 | 1,86 | 1,75 |
| | FR | 248,07 | 1,82 | 1,72 |
| | OR | 262,14 | 1,93 | 1,82 |
| X22 | iv | 193,42 | 1,42 | 1,34 |
| | iv | 202,28 | 1,49 | 1,40 |
| | FR | 194,35 | 1,43 | 1,35 |
| | FL | 188,89 | 1,38 | 1,31 |
| X24 | iv | 0,00 | 0,00 | 0,00 |
| | iv | 0,00 | 0,00 | 0,00 |

| | | | | |
|---|---|---|---|---|
| iv: intravenös (d.h. venöses Blut) FR: Fingerkuppe des Zeigefingers rechts FL: Fingerkuppe des Zeigefingers links OR: Ohrläppchen rechts OL: Ohrläppchen links | | | | |

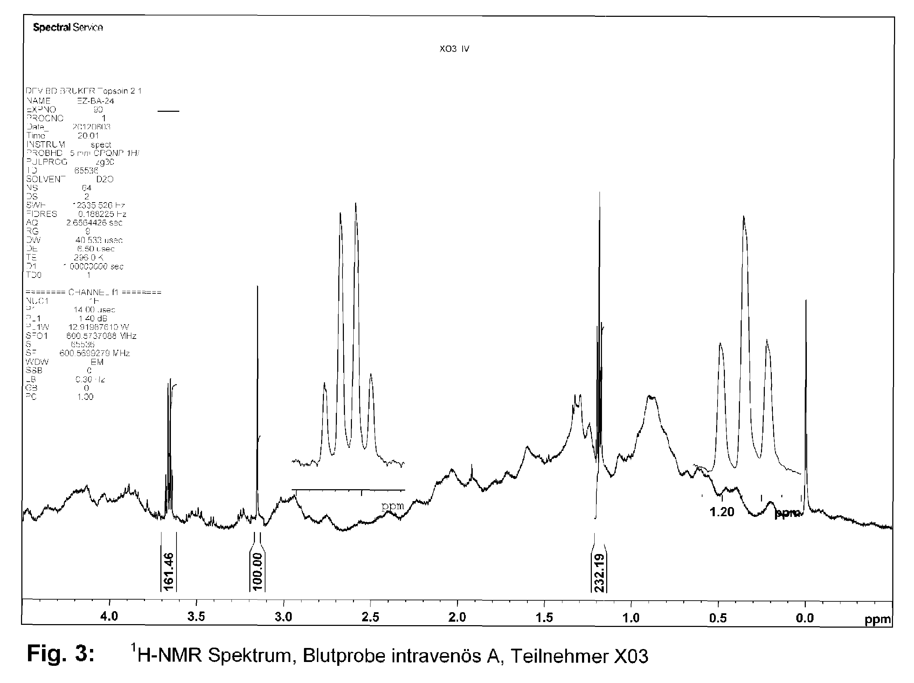

Die Figuren 3 bis 10 zeigen beispielhaft ¹H-NMR-Spektren der Blutproben der zwei Probanden X03 und X12. Der Proband X03 nahm innerhalb von 3 Stunden 3 Bier (je 0,5 l mit ca. 5 Vol.-% Alkohol) 2 Whiskey (je 0,02 I mit ca. 40 Vol.-% Alkohol) und 1 Obstler (0,02 I mit ca. 40 Vol.-% Alkohol) zu sich. Der Proband X12 trank während derselben Zeit nur alkoholfreies Bier. Die Blutproben wurden ca. 45 min nach dem Ende der Trinkphase entnommen. Jedem der Probanden X03 und X12 wurden zwei venöse Blutproben (Proben A und B) und je einmal Kapillarblut von einem Ohrläppchen und einer Fingerkuppe entnommen.

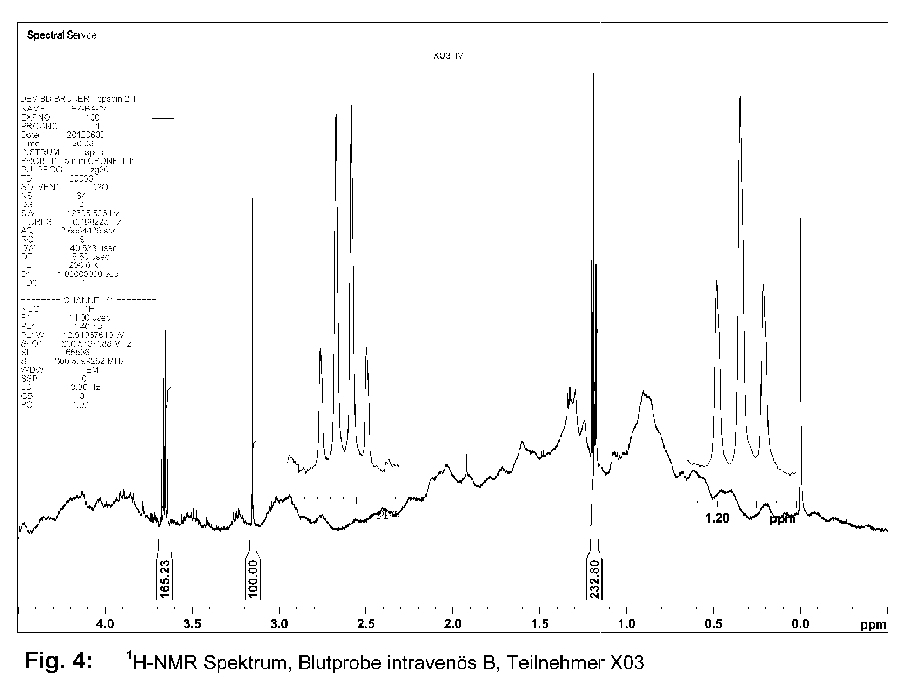

Fig. 3 zeigt das ¹H-NMR-Spektrum der venösen Blutprobe A des Probanden X03. Zusätzlich sind, wie auch in den Spektren der Figuren 4 bis 6, das Quartett der CH₃-Gruppe bei 3,66 ppm und das Triplett der CH₂-Gruppe des Ethanols bei 1,19 ppm vergrößert abgebildet. Bei einer normierten Peakfläche (Integral) von 100,00 für das Signal des internen Standards wurde für das Quartett eine Peakfläche von 161,46 und für das Triplett eine Peakfläche von 232,19 erhalten. Es errechnete sich eine Blutalkoholkonzentration von 1,12 Promille (g/kg).

Fig. 4 zeigt das ¹H-NMR-Spektrum der venösen Blutprobe B des Probanden X03. Bei einer normierten Peakfläche von 100,00 für das Signal des internen Standards wurde für das Quartett eine Peakfläche von 165,23 und für das Triplett eine Peakfläche von 232,80 erhalten und es errechnete sich eine Blutalkoholkonzentration von 1,15 Promille (g/kg).

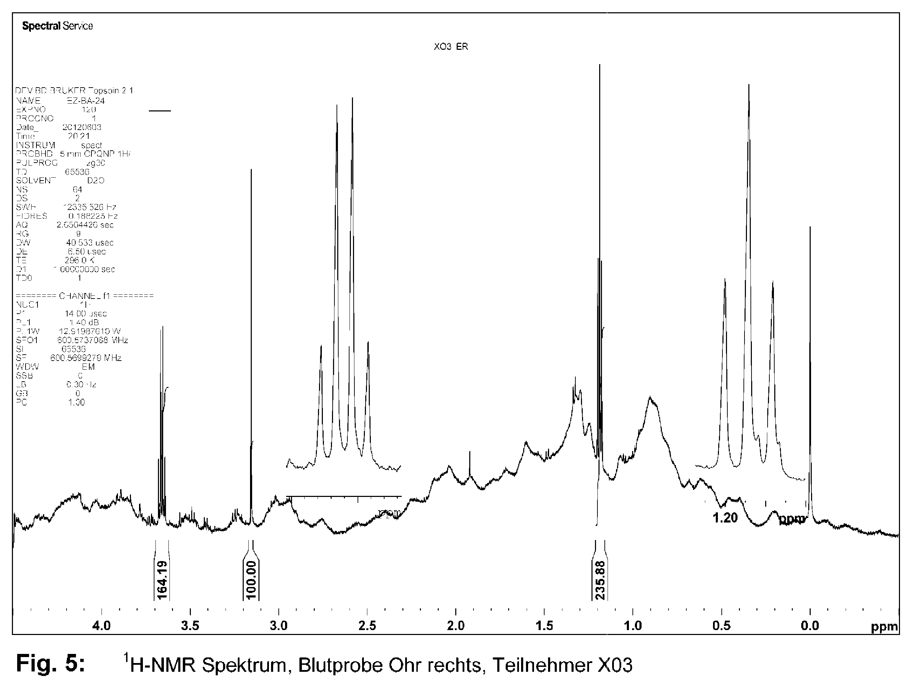

Fig. 5 zeigt das ¹H-NMR-Spektrum des Kapillarbluts aus dem rechten Ohrläppchen des Probanden X03. Bei einer normierten Peakfläche von 100,00 für das Signal des internen Standards wurde für das Quartett eine Peakfläche von 164,19 und für das Triplett eine Peakfläche von 235,88 erhalten und es errechnete sich eine Blutalkoholkonzentration von 1,14 Promille (g/kg). Zusätzlich zu den Signalen des Ethanols konnten geringe Mengen an Isopropanol, das zur Desinfizierung der Einstichstelle verwendet wurde, festgestellt werden.

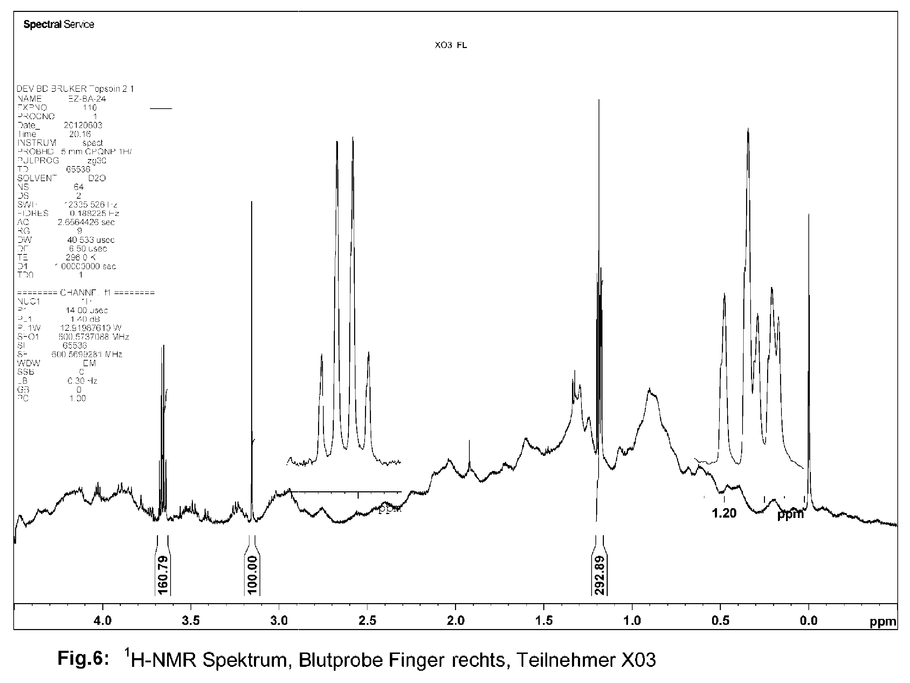

Fig. 6 zeigt das ¹H-NMR-Spektrum des Kapillarbluts aus dem rechten Zeigefinger des Probanden X03. Bei einer normierten Peakfläche von 100,00 für das Signal des internen Standards wurde für das Quartett eine Peakfläche von 160,79 und für das Triplett eine Peakfläche von 292,89 erhalten und es errechnete sich eine Blutalkoholkonzentration von 1,12 Promille (g/kg). Zusätzlich zu den Signalen des Ethanols konnten deutliche Mengen an Isopropanol, das zur Desinfizierung der Einstichstelle verwendet wurde, festgestellt werden.

Der Mittelwert der Blutalkoholkonzentrationen des Teilnehmers X03 über alle 4 Messungen betrug 1,13 Promille (g/kg) bei einer Standardabweichung von 0,01 g/kg bzw. 1,31 %.

Die Überlagerungen der Signale des Desinfektionsmittels Isopropanol (Dublett bei 1,19 ppm) mit dem Triplett des Ethanols waren nicht nachteilig, da die Bestimmung der Menge an Ethanol in der Probe auch über das Quartett des Ethanols möglich war. Bei Verwendung von alkoholfreien Desinfektionsmitteln sind derartige Überlagerungen vermeidbar.

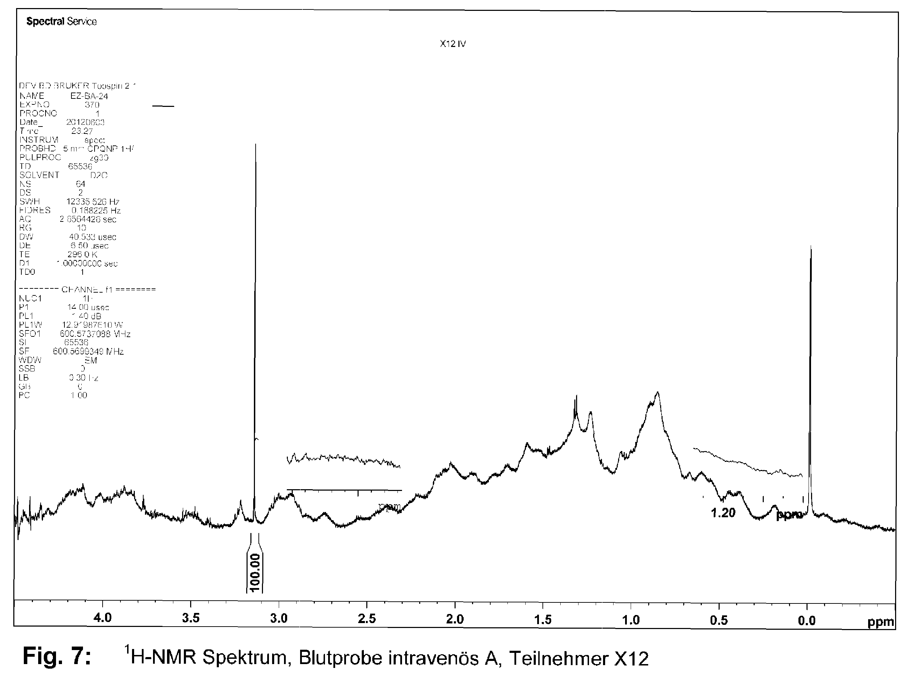

Fig. 7 zeigt das ¹H-NMR-Spektrum der venösen Blutprobe A des Probanden X12. Im Spektrum waren keine Signale von Ethanol zu erkennen.

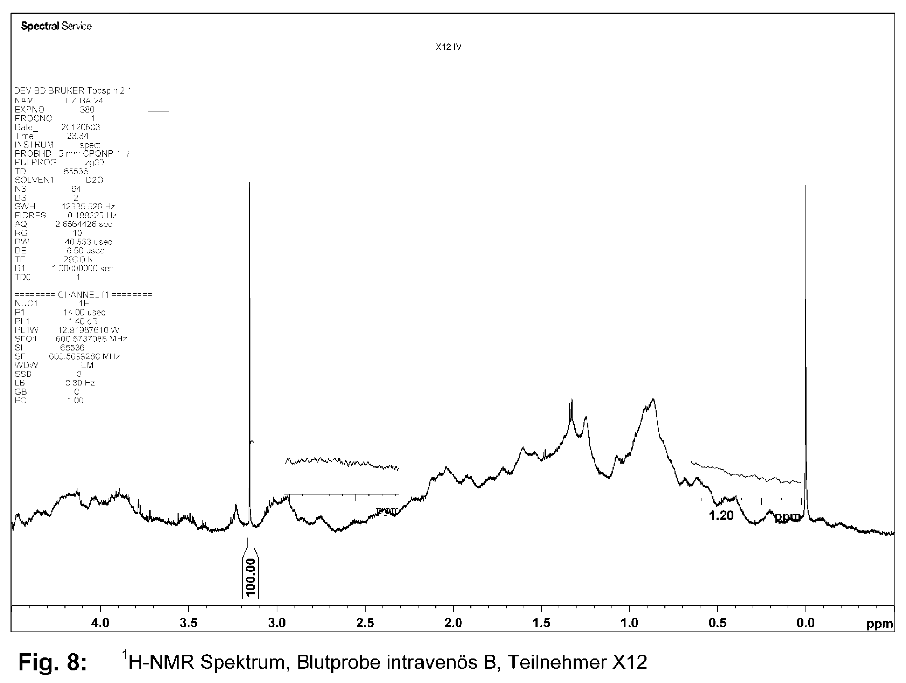

Fig. 8 zeigt das ¹H-NMR-Spektrum der venösen Blutprobe B des Probanden X12. Im Spektrum waren keine Signale von Ethanol zu erkennen.

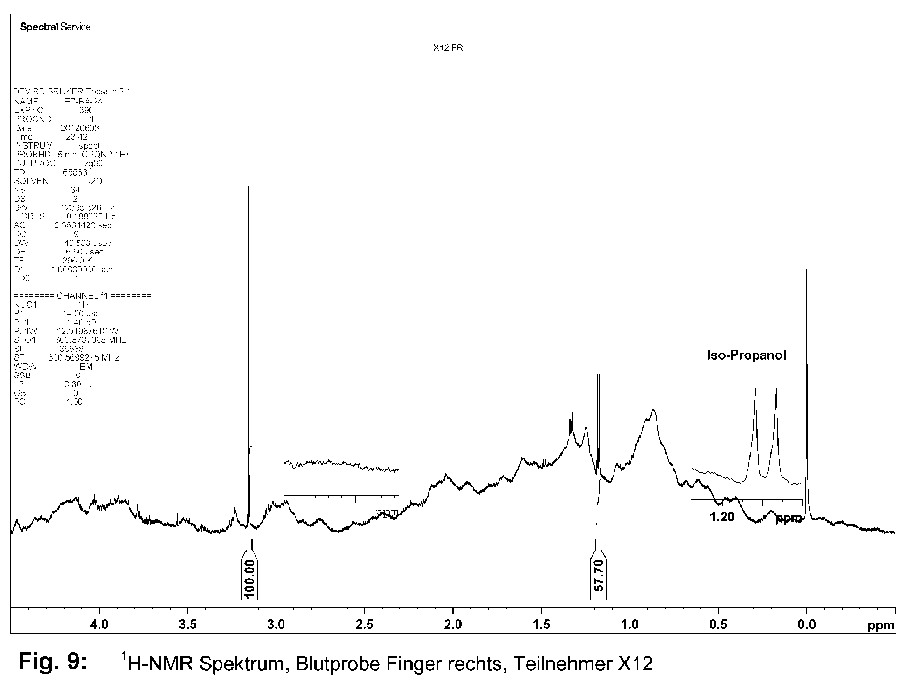

Fig. 9 zeigt das ¹H-NMR-Spektrum des Kapillarbluts aus dem rechten Zeigefinger des Probanden X12. Im Spektrum waren keine Signale von Ethanol zu erkennen. Es konnten jedoch deutliche Mengen an Isopropanol, das zur Desinfizierung der Einstichstelle verwendet wurde, festgestellt werden.

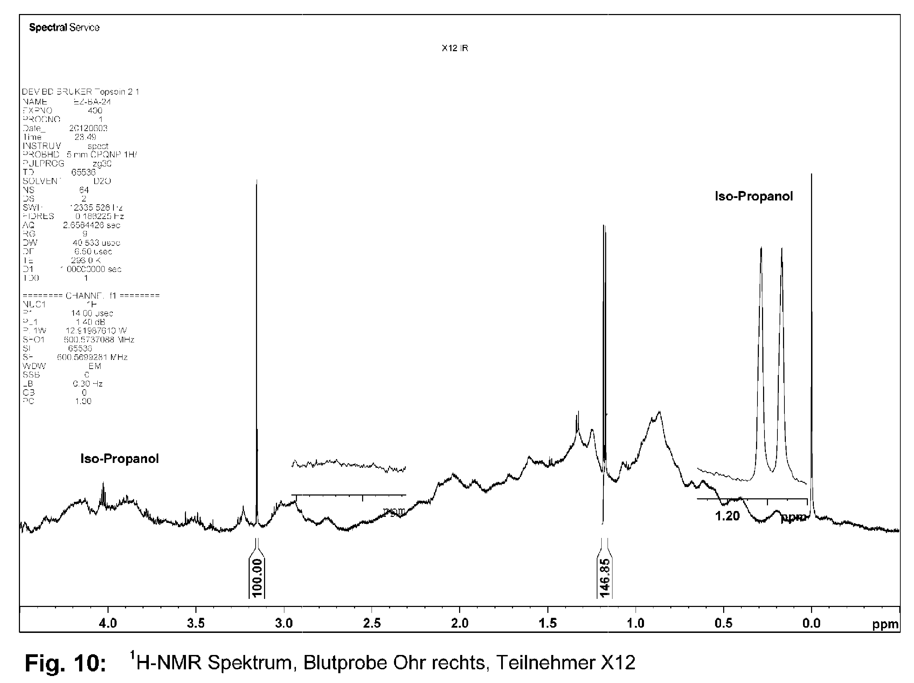

Fig. 10 zeigt das ¹H-NMR-Spektrum des Kapillarbluts aus dem rechten Ohrläppchen des Probanden X12. Im Spektrum waren keine Signale von Ethanol zu erkennen. Es konnten jedoch deutliche Mengen an Isopropanol, das zur Desinfizierung der Einstichstelle verwendet wurde, festgestellt werden.

Wie die oben beispielhaft beschriebenen Spektren der Blutproben der Teilnehmer X03 und X12 zeigen, und wie auch die Untersuchungen der Blutproben der anderen Teilnehmer am Trinktest ergaben, liefert das erfindungsgemäße Verfahren bei der Bestimmung der Blutalkoholkonzentration vergleichbare Ergebnisse bei der Verwendung von Kapillarblut und venösem Blut.

Bei Blutalkoholkonzentrationen von weniger als 1,00 Promille (g/kg) lagen die Differenzen zwischen dem höchsten und dem niedrigsten Einzelwert aus der Summe der Messungen der venösen und Kapillarblutproben eines Teilnehmers bei 0,01 bis 0,07 g/kg. Bei Blutalkoholkonzentrationen von mehr als 1,00 Promille (g/kg) lagen die Differenzen in einem Bereich von 2,31 % bis 9,00 %. Die Standardabweichungen der Blutalkoholkonzentrationswerte lagen zwischen 0,00 und 0,07.

Der Versuch zeigte, dass die Unterschiede zwischen den Alkoholkonzentrationen im venösen Blut und im Kapillarblut so minimal waren, dass sie vernachlässigt werden können. Die Abweichungen sind zudem vergleichbar mit den Abweichungen, die bei den herkömmlichen Analysemethoden ADH und Headspace GC erhalten werden. Die Vergleichbarkeit der intravenösen mit den kapillaren Blutalkoholkonzentrationswerten bedeutet, dass eine Bestimmung der Blutalkoholkonzentration im Kapillarblut möglich und zuverlässig ist. Ein Tropfen aus beispielsweise der Fingerkuppe oder dem Ohrläppchen sind dafür ausreichend.

### Beispiel 4

Es wurden Proben nach einer Lagerung während 7 Monaten bei Raumtemperatur erneut mittels ¹H-NMR-Spektroskopie auf den Blutalkoholgehalt analysiert. Die Proben waren Blutproben von Kapillarblut, das unmittelbar nach der Aufnahme und Abmesung mittels einer Kapillare (20 µl) mit einem Überschuss an D₂O (1 ml) vermischt worden war. Die stabilisierte Blutprobe befand sich in einem luftdicht verschlossenen NMR-Röhrchen und war zum Zwecke der ersten NMR-Messung zudem mit einer vorgegebenen Menge eines internen Standards (20 µl) versetzt.

Tabelle 3 zeigt die Messergebnisse der Messung der Blutalkoholkonzentration nach 7 Monaten Lagerung bei Raumtemperatur im Vergleich mit den ursprünglichen Messungen nach der Blutentnahme.

**Tabelle 3: Messergebnisse der Stabilitätskontrolle nach 7 Monaten**

| Probe Nr. | Blutalkoholkonzentration [g/l] | |
|---|---|---|
| | Messung nach Blutentnahme | Messung nach 7 Monaten |
| 1 | 0,24 | 0,24 |
| 2 | 0,24 | 0,10 |
| 3 | 0,50 | 0,51 |
| 4 | 0,50 | 0,46 |
| 5 | 0,80 | 0,80 |
| 6 | 0,80 | 0,79 |
| 7 | 1,10 | 0,99 |
| 8 | 1,10 | 1,02 |
| 9 | 2,00 | 1,79 |
| 10 | 2,00 | 1,74 |

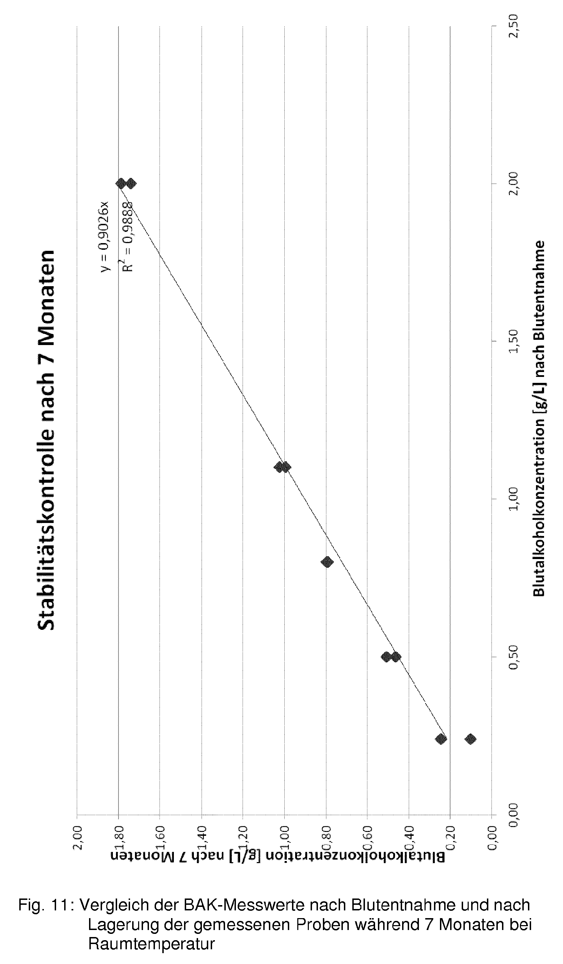

Die erhaltenen Messergebnisse sind grafisch in Fig. 11 dargestellt. Es wurden die Messwerte der Blutalkoholkonzentration nach der Blutentnahme gegen die Messwerte derselben Proben nach einer Lagerung während 7 Monaten bei Raumtemperatur aufgetragen. Es ergibt sich ein Korrelationskurve mit einer Steigung von y = 0,9026x und R² = 0,9888.

Es konnte somit gezeigt werden, dass bei einer mehrmonatigen Lagerung der Blutproben die Blutalkoholkonzentration sich kaum oder nur geringfügig änderte. Dies ist insbesondere überraschen, da die Proben bei Raumtemperatur gelagert wurden. Dieser Effekt ist zurückzuführen auf die stabilisierende Wirkung der Zugabe eines volumenbezogenen Überschusses an deuteriertem Lösungsmittel zu dem entnommenen Blut. Wenn die Proben nach der ersten Messung gekühlt werden, vorzugsweise unter 0 °C, weiter bevorzugt bei mindestens -20 °C, so ist eine noch bessere Stabilisierung möglich.

## Patentansprüche

1. Verfahren zur Bestimmung der Blutalkoholkonzentration mittels ¹H-NMR-Spektroskopie in einer Blutprobe in vitro, wobei die Blutprobe Vollblut ist, umfassend die Schritte:
a) Aufnehmen und Abmessen einer vorgegebenen Menge an Vollblut mittels einer Kapillare;
b) Mischen der vorgegebenen Menge an Vollblut aus Schritt a) mit einem volumenbezogenen Überschuss eines deuterierten Lösungsmittels und mit einer vorgegebenen Menge eines internen Standards,
c) Erstellen eines ¹H-NMR-Spektrums von der in Schritt b) erhaltenen Mischung und
d) Ermitteln der Konzentration an Ethanol in der Blutprobe durch Vergleich der Signale des Ethanols mit den Signalen des internen Standards im erstellten ¹H-NMR-Spektrum.

2. Verfahren nach Anspruch 1, **dadurch gekennzeichnet, dass** das Vollblut der Blutprobe Kapillarblut ist.

3. Verfahren nach Anspruch 2, **dadurch gekennzeichnet, dass** das Kapillarblut aus den Kapillargefäßen eines Ohrläppchen oder einer Fingerkuppe (Fingerbeere) stammt.

4. Verfahren nach einem der vorhergehenden Ansprüche, **dadurch gekennzeichnet, dass** die vorgegebene Menge der Blutprobe in Schritt a) ein Volumen von bis zu 100 µl, vorzugsweise bis zu 50 µl, weiter bevorzugt 3 bis 30 µl und am meisten bevorzugt 5 bis 20 µl an Blut aufweist.

5. Verfahren nach einem der vorhergehenden Ansprüche, **dadurch gekennzeichnet, dass** das in Schritt b) zugegebene Lösungsmittel D₂O oder perdeuteriertes Methanol, vorzugsweise D₂O ist.

6. Verfahren nach einem der vorhergehenden Ansprüche, **dadurch gekennzeichnet, dass** der interne Standard in gelöster Form als Standardlösung zugegeben wird, wobei die Standardlösung eine vorgegebene Konzentration des internen Standards aufweist.

7. Verfahren nach einem der vorhergehenden Ansprüche, **dadurch gekennzeichnet, dass** die im Schritt b) zugegebene vorgegebene Menge des internen Standards mittels einer Kapillare abgemessen wird.

8. Verfahren nach einem der vorhergehenden Ansprüche, **dadurch gekennzeichnet, dass** der Vergleich der Signale des Ethanols mit den Signalen des internen Standards im erstellten ¹H-NMR-Spektrum im Schritt d) ein Vergleich der Integrale der Signale ist.

9. Verfahren nach einem der vorhergehenden Ansprüche, **dadurch gekennzeichnet, dass** für den Vergleich der Signale des Ethanols mit den Signalen des internen Standards im erstellten ¹H-NMR-Spektrum im Schritt d) nur die Signale der CH₃-Gruppe oder der CH₂-Gruppe des Ethanols verwendet werden.

## Claims

1. A method of determining the blood alcohol content by ¹H-NMR spectroscopy in a blood sample in vitro, wherein the blood sample is whole blood, comprising the steps of:
a) collecting and measuring a predetermined amount of whole blood via a capillary;
b) mixing the predetermined amount of whole blood of step a) with a volume-related surplus of a deuterated solvent and a predetermined amount of an internal standard,
c) creating a ¹H-NMR spectrum of the mixture obtained in step b), and
d) determining the concentration of ethanol in the blood sample by comparing the signals of the ethanol with the signals of the internal standard in the ¹H-NMR spectrum created.

2. The method according to claim 1, **characterized in that** the whole blood of the blood sample is capillary blood.

3. The method according to claim 2, **characterized in that** the capillary blood originates from the capillary vessels of an earlobe or a fingertip (finger pad).

4. The method according to one of the preceding claims, **characterized in that** the predetermined amount of the blood sample in step a) has a volume of up to 100 µl, preferably up to 50 µl, more preferably 3 to 30 µl and most preferably 5 to 20 µl of blood.

5. The method according to one of the preceding claims, **characterized in that** the solvent added in step b) is D₂O or perdeuterated methanol, and preferably D₂O.

6. The method according to one of the preceding claims, **characterized in that** the internal standard is added in dissolved form as a standard solution, the standard solution having a predetermined concentration of the internal standard.

7. The method according to any one of the preceding claims, **characterized in that** the predetermined amount of the internal standard added in step b) is measured via a capillary.

8. The method according to any one of the preceding claims, **characterized in that** the comparison of the signals of the ethanol with the signals of the internal standard in the created ¹H-NMR spectrum in step d) is a comparison of the integrals of the signals.

9. The method according to any one of the preceding claims, **characterized in that** for the comparison of the signals of the ethanol with the signals of the internal standard in the created ¹H-NMR spectrum in step d), only the signals of the CH₃ group or the CH₂ group of ethanol are used.

## Revendications

1. Procédé de détermination de la concentration d'alcool dans le sang au moyen de la spectroscopie RMN ¹H dans un échantillon de sang *in* vitro, dans lequel l'échantillon de sang est du sang total, comprenant les étapes de :
a) prélèvement et mesure d'une quantité prédéterminée de sang total au moyen d'un capillaire ;
b) mélange de la quantité prédéterminée de sang total de l'étape a) avec un excédent par rapport au volume d'un solvant deutéré et avec une quantité prédéterminée d'un étalon interne,
c) production d'un spectre RMN ¹H du mélange obtenu à l'étape b) et
d) détermination de la concentration d'éthanol dans l'échantillon de sang par comparaison des signaux de l'éthanol avec les signaux de l'étalon interne dans le spectre de RMN-¹H produit.

2. Procédé selon la revendication 1, **caractérisé en ce que** le sang total de l'échantillon de sang est du sang capillaire.

3. Procédé selon la revendication 2, **caractérisé en ce que** le sang capillaire provient de vaisseaux capillaires du lobe de l'oreille ou du bout d'un doigt (pulpe du doigt).

4. Procédé selon l'une des revendications précédentes, **caractérisé en ce que** la quantité prédéterminée d'échantillon de sang à l'étape a) présente un volume allant jusqu'à 100 µl, de préférence jusqu'à 50 µl, de manière davantage préférée de 3 à 30 µl et de manière préférée entre toutes de 5 à 20 µl de sang.

5. Procédé selon l'une des revendications précédentes, **caractérisé en ce que** le solvant ajouté à l'étape b) est du D₂O ou du méthanol perdeutéré, de préférence du D₂O.

6. Procédé selon l'une des revendications précédentes, **caractérisé en ce que** l'étalon interne est ajouté sous forme dissoute en tant que solution étalon, dans lequel la solution étalon présente une concentration prédéterminée de l'étalon interne.

7. Procédé selon l'une des revendications précédentes, **caractérisé en ce que** la quantité prédéterminée ajoutée à l'étape b) de l'étalon interne est mesurée au moyen d'un capillaire.

8. Procédé selon l'une des revendications précédentes, **caractérisé en ce que** la comparaison des signaux de l'éthanol avec les signaux de l'étalon interne dans le spectre RMN-¹H produit à l'étape d) est une comparaison des intégrales des signaux.

9. Procédé selon l'une des revendications précédentes, **caractérisé en ce que** pour la comparaison des signaux de l'éthanol avec les signaux de l'étalon interne dans le spectre de RMN-¹H produit à l'étape d), seuls les signaux du groupe CH₃ ou du groupe CH₂ de l'éthanol sont utilisés.
